# EUROPÄISCHE PATENTSCHRIFT

(11) **EP 2 662 465 B1**
(45) Veröffentlichungstag und Bekanntmachung des Hinweises auf die Patenterteilung: **19.09.2018**
(21) Anmeldenummer: 13165724.9
(22) Anmeldetag: 29.04.2013
(51) Int. Cl.: C22C 5/04, B21C 1/00, C22F 1/14, G01R 1/06

(54) **Rhodiumlegierung zur Herstellung eines Drahts für Prüfnadeln**
Rhodium alloy for manufacturing a wire for test needles
Alliage de rhodium pour la fabrication d'un fil pour des aiguilles de test

(30) Priorität: 08.05.2012 DE 102012008907
(43) Veröffentlichungstag der Anmeldung: 13.11.2013
(73) Patentinhaber: Heraeus Deutschland GmbH & Co. KG, 63450 Hanau (DE)
(72) Erfinder: STAUDT, Nicole, 61169 Friedberg (DE); WEILAND, Reinhold, 63454 Hanau (DE); SÖRENSEN, Per, 63505 Langenselbold (DE); PRUNZEL, Ingo, 63486 Bruchköbel (DE); LUPTON, David Francis, 63571 Gelnhausen (DE)
(74) Vertreter: Heraeus IP

(56) Entgegenhaltungen:
- US-A1- 2006 197 542
- US-A1- 2010 239 453
- MASSALSKI et Al: "BINARY ALLOY PHASE DIAGRAM", 30. Dezember 1990 (1990-12-30), ASM INTERNATIONAL - William W. Scott, Jr., USA, XP002714038, ISBN: 0-87170-406-4 Bd. 3, Seiten 3249-3249, * das ganze Dokument *

## Beschreibung

Die Erfindung betrifft eine Prüfnadel umfassend einen Draht aus einer Rhodiumbasislegierung und ein Verfahren zur Herstellung einer Prüfnadel aus einer metallischen Legierung, insbesondere aus einer solchen Rhodiumbasislegierung, bei dem die Prüfnadel aus einem Draht geformt wird.
Während der Chipproduktion werden Wafer direkt nach der Prozessierung mit Prüfnadeln kontaktiert, um die Funktionsfähigkeit der integrierten Schaltungen (IC) in ungesägtem Zustand zu testen. Die Prüfnadeln sind in einer Testkarte (probe card) fixiert, die auf das Design des Wafers abgestimmt ist. Beim Prüfprozess wird der Wafer auf die Nadeln gepresst und eine Kontaktierung zwischen Nadeln und den Pads der ICs durch eine Passivierungsschicht hindurch hergestellt. Daraufhin werden verschiedene Parameter getestet, wie zum Beispiel die Kontaktierung, das Durchgangsverhalten bei hoher Stromdichte und das elektrische Verhalten bei Temperaturwechseln.
Für das Testen auf Aluminiumpads sind Prüfnadeln aus den Materialien Wolfram, Wolframcarbid und Wolfram-Rhenium weit verbreitet. Diese sind besonders hart, wobei Aluminiumpads sind robuster als Goldpads sind und einer Prüfung mit harten Nadeln besser standhalten können als Goldpads.
Für die Anwendung auf Goldpads sind Pd-Legierungen bekannt, wie beispielsweise Paliney® H3C der Firma Deringer Ney oder NewTec® der Firma Advanced Probing. Weiterhin existieren PtNi30-Legierungen für Prüfnadeln im Markt. Aus der US 2010/0239453 A1 und der EP 2 248 920 A1 sind niedrig dotierte Iridium-Legierungen zur Herstellung von Prüfnadeln bekannt.

Die US 2006/0197542 A1 offenbart eine Iridium-Basislegierung und eine Platin-Basislegierung zum Herstellen von Prüfnadeln. Die Legierungen weisen eine hohe Härte zwischen 300 HV und 500 HV auf, um einen guten Kontakt durch eine auf den Goldpads angeordnete Lackschicht herstellen zu können.

Iridium hat den Nachteil, dass es eine geringere Wärmeleitfähigkeit und elektrische Leitfähigkeit als andere Metalle hat.

Nachteilig ist bei diesen Legierungen auch, dass die Spitzen angeschliffen werden müssen, was ein teurer und häufig manuell durchgeführter Prozess ist.

Weiterhin können Prüfstrukturen in geringem Umfang mikrosystemtechnisch hergestellt werden. Nachteilig sind dabei die hohen Herstellungskosten.

Die Härte der Legierungen ist für mit Lack beschichtete Goldpads zwar ausreichend, die aus der Legierung gefertigten Prüfnadeln könnten jedoch für Aluminiumpads vorteilhaft noch härter sein, da die Aluminiumpads unempfindlicher sind.

Die Aufgabe der Erfindung besteht also darin, die Nachteile des Stands der Technik zu überwinden. Insbesondere soll eine Metall oder eine Legierung gefunden werden, aus der Prüfnadeln herstellbar sind, die eine größere Wärmeleitfähigkeit und elektrische Leitfähigkeit aufweist. Zudem soll eine ausreichende Oxidationsbeständigkeit gegeben sein, damit die Oberflächen aus dem Metall oder der Legierung nicht durch Oxidation passiviert werden. Ferner soll das Material eine ausreichend hohe Härte aufweisen, um möglichst eine lange Standzeit und nur eine geringe oder keine Beschädigungen von Goldpads zu garantieren. Gleichzeitig soll auch eine große Härte zum Einsatz als Prüfnadeln für Aluminiumpads einstellbar sein. Eine weitere Aufgabe der Erfindung ist darin zu sehen, dass eine einfache Verarbeitung möglich ist, mit der Drähte mit Durchmessern von 0,05 bis 0,15 mm, beispielsweise von 0,08 mm, in einem Standardprozess daraus zu fertigen sind und eine hohe Geradheit der Prüfnadeln herstellbar ist, um eine exakte Kontaktierung der Kontakt (Goldpads oder Aluminiumpads) zu ermöglichen. Gleichzeitig sollte eine erfindungsgemäße Legierung oder ein erfindungsgemäßes Metall eine ausreichende Elastizität besitzen, damit sich die Prüfnadeln nicht bei der Kontaktierung plastisch verformen und um die Toleranzen beim Herstellen von Testkarten mit solchen Prüfnadeln möglichst groß zu halten.

Eine weitere Aufgabe der Erfindung liegt darin eine Prüfnadel bereitzustellen, die die zuvor genannten Eigenschaften erfüllt.

Die Aufgabe der Erfindung wird gelöst durch eine Prüfnadel umfassend einen Draht aus einer Rhodiumbasislegierung, dadurch gekennzeichnet, dass die Rhodiumbasislegierung 0,01 Gew% bis 1 Gew% Zirkonium, optional 0,001 Gew% bis 1 Gew% Yttrium und/oder 0,001 Gew% bis 1 Gew% Cer und/oder 0,01 Gew% bis 30 Gew% Platin und/oder 0,01 Gew% bis 30 Gew% Iridium umfasst, vorzugsweise 0,01 Gew% bis 0,5 Gew% Yttrium und/oder 0,01 Gew% bis 0,5 Gew% Cer und/oder 5 Gew% bis 30 Gew% Platin und/oder 4 Gew% bis 30 Gew% Iridium, ganz besonders bevorzugt 5 Gew% bis 15 Gew% Platin und/oder 4 Gew% bis 15 Gew% Iridium, und der Rest der Rhodiumbasislegierung aus Rhodium besteht, wobei der Draht einen Durchmesser von 20 µm bis 200 µm aufweist.

Durch das Zulegieren von Platin und/oder Iridium können die mechanischen Eigenschaften der Rhodiumbasislegierung verbessert werden. Insbesondere wird die Elastizität der Prüfnadeln, die aus einer solchen Rhodiumbasislegierung hergestellt wurden, verbessert.

Besonders bevorzugte Prüfnadeln können sich dadurch auszeichnen, dass vorgesehen ist, dass die Rhodiumbasislegierung des Drahtes eine Kornfeinung aufweist, insbesondere ein gleichkörniges Feingefüge aufweist.

Durch die Kornfeinung beziehungsweise das gleichkörnige Feingefüge wird eine gute Verformbarkeit der Rhodiumbasislegierung erreicht, so dass sich lange Drähte zur Herstellung der Prüfnadeln ziehen lassen.

Dabei kann vorgesehen sein, dass die mittlere Korngröße der Rhodiumbasislegierung zwischen 0,01 µm und 2 µm liegt, vorzugsweise zwischen 0,02 µm und 0,5 µm, besonders bevorzugt zwischen 0,05 µm und 0,1 µm.

Des Weiteren kann vorgesehen sein, dass die Rhodiumbasislegierung eine Härte von 350 HV bis 800 HV, vorzugsweise im zieharten Zustand einen Härte von 500 HV bis 750 HV und/oder in einem wärmebehandelten Zustand eine Härte von 400 HV bis 650 HV hat.

Diese Härten sind sowohl zur Kontaktierung von Goldpads als auch von Aluminiumpads geeignet.

Auch kann vorgesehen sein, dass die Rhodiumbasislegierung einen spezifischen Widerstand zwischen 5 µΩ cm und 5,5 µΩ cm aufweist.

Ferner kann vorgesehen sein, dass die Rhodiumbasislegierung eine kubisch flächenzentrierte Kristallstruktur aufweist.

Bei einer weiteren erfindungsgemäß besonders bevorzugten Ausgestaltung der Erfindung kann vorgesehen sein, dass die Rhodiumbasislegierung 0,05 Gew% bis 0,8 Gew% Zirkonium umfasst, bevorzugt 0,1 Gew% bis 0,6 Gew% Zirkonium.

Diese Zusammensetzungen bewirken eine besonders gute nachträgliche Aushärtbarkeit des Materials, so dass die Härte zu einem späten Zeitpunkt einstellbar ist, was insbesondere für die Anwendung bei Prüfnadeln besonders vorteilhaft ist.

Ferner kann vorgesehen sein, dass der Draht der Prüfnadel vorzugsweise einen Durchmesser von 50 µm bis 150 µm, besonders bevorzugt einen Durchmesser von 70 µm bis 90 µm aufweist.

Auch kann vorgesehen sein, dass der Draht mit einem Spannungsprüfer elektrisch verbunden ist, wobei der Spannungsprüfer an ein zu prüfendes elektrisches Bauteil anschließbar oder angeschlossen ist.

Die Aufgaben der Erfindung werden ferner gelöst durch ein Verfahren zur Herstellung einer Prüfnadel aus einer metallischen Legierung, insbesondere aus einer solchen Rhodiumbasislegierung, bei dem ein Draht aus der metallischen Legierung hergestellt, insbesondere gezogen oder gewalzt wird und das Material anschließend durch eine Temperaturbehandlung gehärtet wird, wobei die Härte durch die Temperaturbehandlung eingestellt wird, wobei die Prüfnadel aus dem Draht geformt wird.

Dabei kann vorgesehen sein, dass die Temperaturbehandlung bei einer Temperatur zwischen 150 °C und 600 °C erfolgt, bevorzugt bei einer Temperatur zwischen 200 °C und 400 °C, und die Temperaturbehandlung über einen Zeitraum von zumindest 10 Minuten erfolgt.

Ferner kann dabei vorgesehen sein, dass die Spitze der Prüfnadel durch Ätzen geformt wird.

Der Erfindung liegt die überraschende Erkenntnis zugrunde, dass es durch das Zulegieren von Zirkonium zu Rhodium gelingt, ein härtbares Material bereitzustellen, das die notwendige Elastizität und Härte aufweist, um als Prüfnadel verwendet zu werden, und das zuvor leicht bearbeitet werden kann, so dass die Herstellung der Prüfnadeln ohne großen Aufwand durchgeführt werden kann. Anschließend kann die Härte durch Glühen, beziehungsweise Tempern des Drahts beziehungsweise der vorgefertigten Prüfnadel eingestellt werden, dabei kann eine Härte variabel eingestellt werden, die zum Prüfen des Kontakts von lackbeschichteten Goldpads oder von Aluminiumpads geeignet ist. Die erfindungsgemäße Rhodiumbasislegierung lässt sich zudem gut ätzen, so dass die Spitzen der Prüfnadeln ainfach und unaufwendig geätzt werden können.

Der vorliegenden Erfindungsmeldung liegt also auch die Idee zugrunde, Prüfnadeln aus niedrig legierten Rhodiumbasislegierungen zu verwenden, um Goldpads oder Aluminiumpads zerstörungsfrei und sicher kontaktieren.

Die Anforderungen an eine geeignete Legierung sind:
1) Hohe elektrische und thermische Leitfähigkeit;
2) Gute Oxidationsbeständigkeit;
3) Hohe Härte, um eine lange Standzeit und gegebenenfalls nur eine geringe oder keine Beschädigungen der Goldpads zu garantieren;
4) Hohe Geradheit der Prüfnadeln, für eine präzise Kontaktierung;
5) Einfache Verarbeitung möglich, das heißt, geeignet, um Drähte mit Durchmessern von 0,05 bis 0,15 mm, beispielsweise von 0,08 mm, in einem Standardprozess daraus zu fertigen; und
6) Ausreichende Elastizität, da sich die Nadeln bei der Kontaktierung nicht verbiegen sollen.

Diese Anforderungen werden durch erfindungsgemäße Rhodiumbasislegierungen erfüllt.

Im Vergleich zu niedrig dotierten Iridium-Legierungen oder Platinbasis-Legierungen, bei denen die Spitzen angeschliffen werden müssen, was ein teurer, häufig manuell durchgeführter Prozess ist, können erfindungsgemäße Rhodiumbasislegierungen hingegen geätzt werden, was deutliche Einsparungen gegenüber den nicht ätzbaren Materialien bedeutet.

Erfindungsgemäße Rhodiumbasislegierungen können sich gemäß einer besonders bevorzugten Ausführungsform der Erfindung dadurch auszeichnen, dass neben dem Zulegieren von Zirkonium zu Rhodium auch eine Dotierung von weniger als 500 ppm Yttrium und/oder Cer vorgesehen sein kann.

Durch die mit der Zulegierung von Zirkon oder auch von Zirkon und weiteren Metallen, wie Cer oder Yttrium einhergehende Kornfeinung des Gefüges erfindungsgemäßer Rhodiumbasislegierungen wird das Kornwachstum auch bei höheren Temperaturen behindert und somit eine gute Verformbarkeit bis in einen Durchmesserbereich von 50 µm bis 150 µm erreicht. Die Verformbarkeit bewirkt, dass die aus erfindungsgemäßen Rhodiumbasislegierungen hergestellten Prüfnadeln kostengünstig auch in Serie herstellbar sind. Die Dichte der Kontaktpads steigt aufgrund der technischen Anforderungen an, so dass auch der Durchmesser der Prüfnadeln abnehmen muss, was mit erfindungsgemäßen Rhodiumbasislegierungen möglich ist. Weiterhin wird durch die Zugabe der oben genannten Elemente eine, im Gegensatz zu reinem Rhodium, aushärtbare Legierung erzeugt. Das heißt, dass nach der Verformung an den Zieldurchmesser das Material durch Glühen ausgehärtet werden kann.

Der Härtewerte erfindungsgemäßer Rhodiumbasislegierungen im ziehharten Zustand beträgt dabei 500 HV bis 750 HV, während der Härtewerte der erfindungsgemäßen Rhodiumbasislegierung im wärmebehandelten Zustand 400 HV bis 650 HV liegt.

Insgesamt werden die für den beschriebenen Zweck guten elektrischen Eigenschaften des unlegierten Rhodiums durch die geringe Zugabe von Zirkonium und der anderen genannten Elemente, wie Yttrium und/oder Cer in nur sehr geringem Maße negativ beeinflusst. Der spezifische Widerstand von Rhodium beträgt 4,73 µΩ cm (36,5% IACS - eine auf Kupfer (100% I-ACS) bezogene Standardleitfähigkeit) ist vergleichbar mit der erfindungsgemäßer Rhodiumbasislegierungen 5,20 µΩ cm (33,2% IACS).

Prüfnadeln aus erfindungsgemäßen niedrig legierten Rh-legierungen bieten dabei neben der im Vergleich zu anderen verwendeten Legierungen guten elektrischen und thermischen Leitfähigkeit zusätzlich die folgenden Vorteile:
Die Prüfnadeln haben eine gute Oxidationsbeständigkeit, für einen dauerhaft geringen Kontaktwiderstand.

Die Prüfnadeln weisen eine hohe Härte, für eine lange Standzeit auf.

Zudem ergibt sich mit erfindungsgemäßen Rhodiumbasislegierungen eine hohe Elastizität und Gradheit der Prüfnadeln, mit denen ein präzises Kontaktieren möglich ist.

Nicht zuletzt haben die beschriebenen, erfindungsgemäßen Rhodiumbasislegierungen den großen Vorteil, ätzbar zu sein. Die gute Ätzbarkeit dünner Rhodiumschichten ist bei der Herstellung und Instandhaltung der Prüfnadeln vorteilhaft. Ätzmedien werden für das Strukturieren von dünnen Rhodiumschichten beispielsweise in der US 3,240,684 A beschrieben.

Im Folgenden wird ein Ausführungsbeispiel der Erfindung anhand einer schematisch dargestellten Figur 1 und zweier Grafiken in den Figuren 2 und 3 erläutert, ohne jedoch dabei die Erfindung zu beschränken.

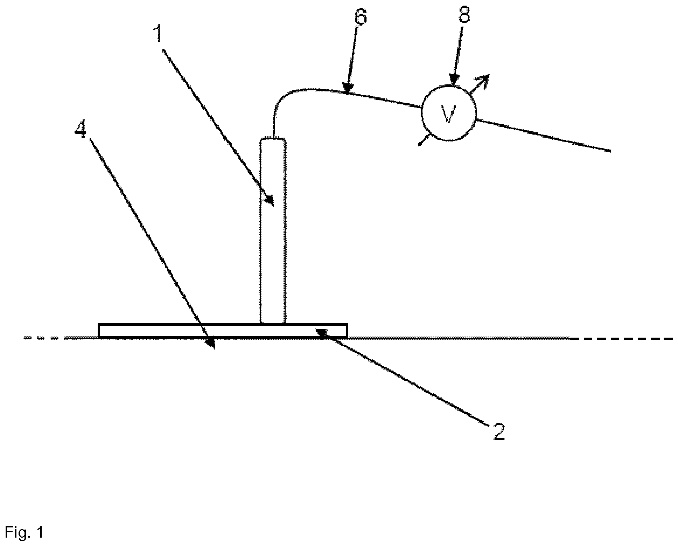

Die Figur 1 zeigt dabei eine schematische Querschnittansicht einer erfindungsgemäßen Prüfnadel 1 aus einer erfindungsgemäßen Rhodiumbasislegierung. Die Prüfnadel 1 wird auf ein Goldpad 2 auf einem Wafer 4 gedrückt, um die Qualität einer aus dem Wafer 4 erzeugten elektronischen Struktur zu prüfen. Dazu ist die Prüfnadel 1 über eine elektrische Leitung 6 und ein Spannungsmessgerät 8 mit einem anderen Teil (nicht gezeigt) der elektronischen Struktur des Wafers 4 verbunden.

Wenn die Prüfnadel 1 auf das Goldpad 2 drückt, wird der Stromkreis geschlossen, wenn die elektronische Struktur intakt ist. Das Schließen des Stromkreises kann mit Hilfe des Spannungsmessgeräts 8 bestimmt werden. Zudem kann auch die Qualität der erzeugten elektrischen Verbindungen so geprüft werden.

Bei einer Prüfkarte wird eine Vielzahl von solchen Prüfnadeln 1 fest über einen Kartenkörper verbunden, um mit einem einzigen Aufdrücken der Prüfkarte eine Vielzahl von elektrischen Verbindungen zu prüfen.

Mit Hilfe des Spannungsmessgeräts 8 kann auch die Qualität der elektrischen Verbindungen geprüft werden. Die entsprechenden Prüfverfahren sind im Stand der Technik bekannt und es soll hier nicht näher darauf eingegangen werden.

Durch Versuche mit reinem Rhodium wurde die Herstellbarkeit von Drähten für Prüfnadeln bis zu einem Durchmesser von 0,08 mm nachgewiesen. Allerdings zeigte das reine Rhodium ein zu plastisches Verhalten. Die hergestellten Prüfnadeln verformten sich also bei zu geringem Druck auf die zu prüfende Oberfläche plastisch, also irreversibel.

Außerdem wurden verschiedene niedrig legierte Rhodiumbasisegierungen hergestellt und das Schmiedeverhalten untersucht. Alle untersuchten Legierungen zeigten ein gutes bis sehr gutes Verformungsverhalten.

Es wurden das Umformverhalten durch Schmiede- und Walzprozesse (warm/kalt) untersucht und die Aushärtbarkeit der Legierungen bei Temperaturen bis zu 500 °C ermittelt.

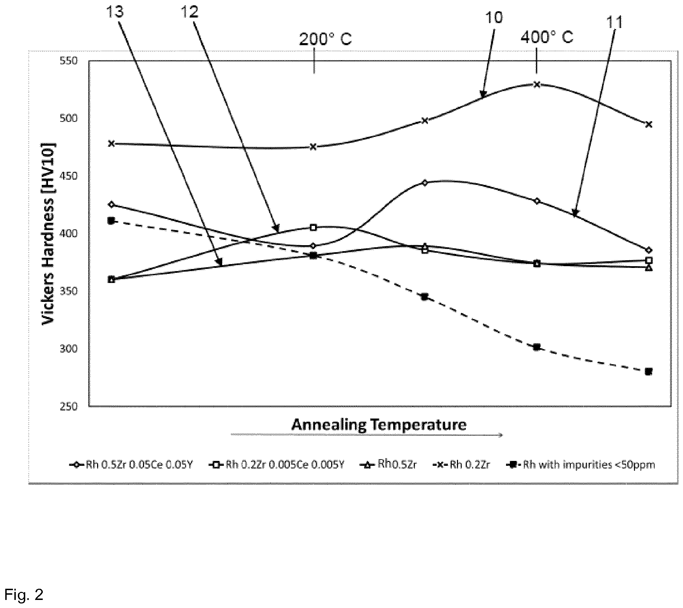

Alle Legierungen ließen sich ohne Risse gut verformen und teilweise signifikant besser aushärten, was vermutlich maßgeblich auf die Bildung von Ausscheidungen in den Legierungen zurückzuführen ist. Die Zunahme der Härte betrug bis zu 51 HV ausgehend von einer Härte von 478 HV bei Raumtemperatur (Figur 2). Damit konnte gezeigt werden, dass für einzelne Vertreter der hier behandelten Rhodiumbasisegierungen wichtige Grundvoraussetzungen für das Erfüllen der zuvor formulierten Anforderungen gegeben sind.

Geeigneten Legierungskandidaten wurden mit dem Ziel verarbeitet, Drähte mit einem Durchmesser (D) von 0,080 mm herzustellen. Dafür wurde eine Legierung bestehend aus einer entsprechenden Vorlegierung sowie 99,9% reines Rhodium in einer Lichtbogen- beziehungsweise lonenstrahlschmelze oder Elektronenstrahlschmelze hergestellt. In mehreren Durchgängen wurden die Barren bei 1200°C heiß geschmiedet. Nachfolgend wurden die Barren kalibergewalzt und Drähte im Heißzug an D = 0,3 mm und dann kalt an D = 0,080 mm gezogen, dazwischen mehrfach geglüht.

Es wurden mechanische Eigenschaften anhand von Zugversuchen und Härteanalysen im Schliff, die Verarbeitbarkeit durch die Häufigkeit von Drahtabrissen sowie die Ausbringung in Gramm in einem Stück, die Aushärtbarkeit mittels Temperatur-Härte-Kurven sowie die Leitfähigkeit durch eine 4-Punkt-Messung an einem 1000 mm langen Drahtstück beurteilt beziehungsweise gemessen.

Tabelle 1: Die nachfolgende Tabelle 1 definiert eine Referenz A als reines Rhodium und vier verschiedene erfindungsgemäße Rhodiumbasislegierungen B bis E mit ihren jeweiligen Zusammensetzungen:

| **Tabelle 1** | **Rh (Gew-%)** | **Zr (Gew-%)** | **Ce (Gew-%)** | **Y (Gew-%)** |
|---|---|---|---|---|
| Rhodium A | 100 | 0 | 0 | 0 |
| Legierung B | Rest | 0,5 (5000ppm) | 0 | 0 |
| Legierung C | Rest | 0,2 | 0 | 0 |
| Legierung D | Rest | 0,5 | 0,05 | 0,05 |
| Legierung E | Rest | 0,2 | 0,05 | 0,05 |

Figur 2 dient dem Nachweis der Aushärtbarkeit erfindungsgemäßer Rhodiumbasislegierungen. Diese zeigen teilweise in den Versuchen die höchste Härte und stärkste Aushärtung infolge von Ausscheidungen. In dem genannten Legierungsbereich lassen sich noch weitere erfindungsgemäße Legierungszusammensetzungen für Rhodiumbasislegierungen finden. Die Grafik nach Figur 2 zeigt die Vickershärte (Vickers Hardness [HV10]) gegen die Temperungstemperatur beziehungsweise Glühtemperatur (Annealing Temperature [°C]) von vier besonders bevorzugten Rhodiumbasislegierungen. Die oberste Kurve 10 zeigt die Härte einer Rhodiumbasislegierung mit 0,2 Gew% Zirkonium (Legierung C), die zweitoberste Kurve 11, die bei einer Temperung bei 400 °C die zweithöchste Härte aufweist, zeigt die Härte einer Rhodiumbasislegierung mit 0,5 Gew% Zirkonium, 0,05 Gew% Yttrium und 0,05 Gew% Cer (Legierung D), die drittoberste Kurve 12, die bei einer Temperung bei 200 °C die zweithöchste Härte aufweist, zeigt die Härte einer Rhodiumbasislegierung mit 0,2 Gew% Zirkonium, 0,005 Gew% Yttrium und 0,005 Gew% Cer (Legierung E) und die viertoberste Kurve 13, die bei einer Temperung bei 200 °C die niedrigste Härte aller Rhodiumbasislegierungen aufweist, zeigt die Härte einer Rhodiumbasislegierung mit 0,5 Gew% Zirkonium (Legierung B). Zusätzlich ist in Figur 2 die Härte von getempertem Rhodium in Reinform mit Verunreinigungen von weniger als 50 ppm gezeigt (gestrichelte Linie). deutlich zeigt sich die Überlegenheit erfindungsgemäßer Rhodiumbasislegierungen bei einer Temperung bei Temperaturen von 200° C und höheren Temperaturen. Die Temperung erfolgte jeweils über eine Glühdauer von 30 Minuten.

Es konnten signifikant verbesserte mechanische Eigenschaften in Versuchen auch für erfindungsgemäße Rhodiumbasislegierungen gemessen werden. Die Versuche wurden im ziehharten Zustand durchgeführt.

Tabelle 2: Mechanische Eigenschaften von Rhodium und den Rhodiumbasislegierungen. 0,025 g ist das Gewicht des Prüfstempels zur Bestimmung der Härte nach Vickers (HV0,025).

| Material | Zugfestigkeit | Härte |
|---|---|---|
| | N/mm² | HV0,025 |
| Rh (Referenz) | 1570 | 520 |
| RhZr0,2 | 2200-3300 | 480-690 |
| RhZr0,5 | 2400-3090 | 490-650 |

Des Weiteren wurde festgestellt, dass die Zugabe von Zirkon sowie Yttrium und Cer zu Rhodium zu einer deutlich verbesserten Verarbeitbarkeit von dünnen Drahtquerschnitten bis 0,050 mm zur Folge hat.

Tabelle 3: Verarbeitbarkeit erfindungsgemäßer Legierungen und von Rhodium: Es wurde bei gleicher Herstellung die Anzahl der Drahtabrisse pro einhundert Meter gezogenem Draht bestimmt. Zusätzlich ist das Gewicht des durchschnittlich hergestellten Drahts angegeben, das heißt, wie schwer die gezogenen Drähte durchschnittlich werden konnten, bevor diese Abbrachen.

| Material | Drahtabrisse | Ausbringung |
|---|---|---|
| | pro 100m | 9 |
| Legierung A | 18 | <0,5 |
| Legierung B | 1 | >5 |
| Legierung C | 2 | >6 |
| Legierung D | 2 | >7 |
| Legierung E | 3 | >5 |

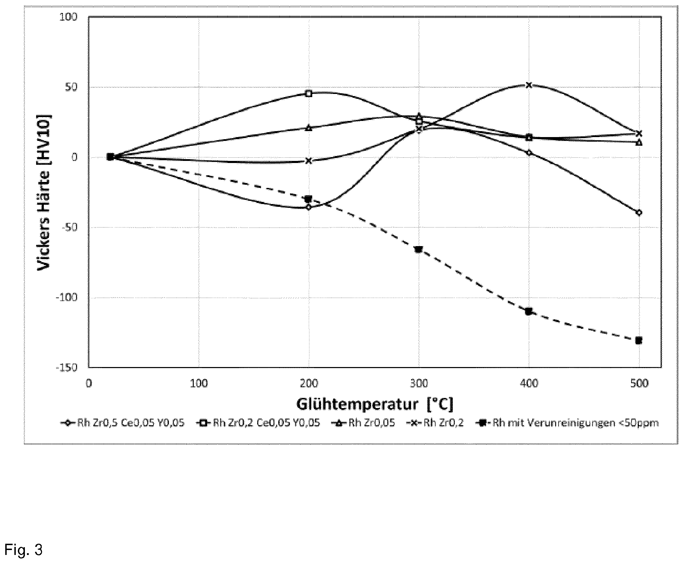

Die Aushärtbarkeit der vorgestellten Legierungen wird in Figur 3 anhand von Härtemessungen bei verschiedenen Glühtemperaturen gezeigt. Figur 3 zeigt dabei die Änderung der Härte nach Vickers (HV) in Abhängigkeit von der Glühtemperatur in °C. Durch die nachträgliche Aushärtung kann die Endhärte nachträglich angehoben werden. Damit ist eine Umformung bei geringerer Festigkeit möglich, was sich positiv auf das Umformergebnis (beispielsweise die Geradheit der Prüfnadeln) auswirkt. Außerdem kann erfindungsgemäß durch die Einstellung der Härte die Anwendung des Materials für Goldpads beziehungsweise Aluminiumpads eingestellt werden.

Während bei reinem Rhodium die Härte bei einer Temperaturbehandlung abnimmt, kann bei den erfindungsgemäßen Rhodiumbasislegierungen zunächst eine Umformung beziehungsweise eine Herstellung der Prüfnadeln erfolgen und anschließend die Härte durch eine nachgelagerten Temperaturbehandlung eingestellt beziehungsweise insbesondere erhöht werden.

In Experimenten konnte gezeigt werden, dass Zirkon in den genannten Konzentrationsbereichen einen positiven Einfluss auf die Verarbeitbarkeit und Aushärtung des Rhodiums hat. Durch das Zulegieren von Zirkon (besonders mit 0,2 Gew% Zr und mit 0,5 Gew% Zr) können erfindungsgemäße Rhodiumbasislegierungen zu rissfreien Drähten mit Durchmessern von 0,080 mm verarbeitet werden. Die erreichbare Härte liegt bei über 620 HV. Die Verwendung als Prüfnadel erfordert eine Härte von 450 bis 500 HV und kann zugunsten einer optimieren Gradheit der Prüfnadel bei erfindungsgemäßen Rhodiumbasislegierungen mittels eines nachgeschalteten Richt-Temper-Vorgangs eingestellt werden. Das Zulegieren von Yttrium und Cer führt ebenfalls zu einer Härtesteigerung und verbesserten Verarbeitbarkeit. Reines Rhodium, beziehungsweise Rhodium mit prozessbedingten Verunreinigungen von Platin und Iridium bis 100 ppm, zeigt diesen Effekt nicht (siehe Figuren 2 und 3). Die Verarbeitung zu rissfreien Drähten von Durchmessern von 0,080 mm konnte mit Prüfnadeln aus einem solchen reinen Rhodium nicht zu einem serientauglichen Prozess geführt werden.

Biegeversuche an Drähten aus RhPt₅Zr_{0,05} und RhIr₆Zr_{0,05} zeigen, dass diese Materialkompositionen hervorragend geeignet sind, die besonderen Anforderungen an die Elastizität von Prüfnadeln zu erfüllen.

Insgesamt wurde ermittelt, dass es sich bei der erfindungsgemäßen Legierungsfamilie um eine hochleitfähige Legierung handelt, die sich gegenüber den am Markt etablierten Palladiumlegierungen durch eine sehr hohe elektrische Leitfähigkeit auszeichnet.

Während die elektrische Leitfähigkeit von Palladium bei nur 9,26 10⁶ A/(V m) liegt und die von Rhodium bei 23,3 10⁶ A/(V m) (40 %IACS), wurden für die Rhodiumbasislegierung mit 0,2 Gew% Zirkonium (Legierung C) eine elektrische Leitfähigkeit von 18,5 10⁶ A/(V m) (32 %IACS) gemessen, für die Rhodiumbasislegierung mit 0,5 Gew% Zirkonium, 0,05 Gew% Yttrium und 0,05 Gew% Cer (Legierung D) eine elektrische Leitfähigkeit von 16,8 10⁶ A/(V m) (29 %IACS), für die Rhodiumbasislegierung mit 0,2 Gew% Zirkonium, 0,005 Gew% Yttrium und 0,005 Gew% Cer (Legierung E) eine elektrische Leitfähigkeit von 18 10⁶ A/(V m) (31 %IACS) und für die Rhodiumbasislegierung mit 0,5 Gew% Zirkonium (Legierung B) eine elektrische Leitfähigkeit von 18 10⁶ A/(V m). Die Bestimmung der Leitfähigkeit erfolgte unter den folgenden Bedingungen: 4-Punkt-Messung mit U = 10 V und I = 10 mA. Berechnung des Widerstands über Messung des Spannungsabfalls. Für die Berechnung des %IACS-Werts wird die spezifische Leitfähigkeit ins Verhältnis gesetzt zu der spezifischen Leitfähigkeit von geglühtem Kupfer (100% IACS = 58 MS/m)

Während also die Härte erfindungsgemäßer Rhodiumbasislegierungen nach einer Temperaturbehandlung deutlich verbessert ist, wird die elektrische Leitfähigkeit kaum reduziert. Durch die erfindungsgemäßen Rhodiumbasislegierungen wird es also möglich, einen dünnen Draht herzustellen, der besser als Palladium zur Herstellung einer Prüfnadel geeignet ist, während ein entsprechender Draht aus reinem Rhodium nicht für den genannten Zweck herstellbar ist. Vorteilhafter Weise kann bei den erfindungsgemäßen Rhodiumbasislegierungen also eine nachträgliche Härtung des Materials durch eine Temperaturbehandlung nach der Herstellung der Prüfnadeln erfolgen.

Das Zulegieren von geringen Mengen Yttrium, Cer und Zirkon zu Rhodium führt zu einer deutlich erhöhten Rekristallisationstemperatur und verbesserten mechanischen Eigenschaften. Dies kann vermutlich auf Ausscheidungen von Rhodium-Zirkonium-Phasen an den Korngrenzen zurückgeführt werden. Rhodium ist deshalb besonders interessant, weil es eine hohe Leitfähigkeit besitzt, die für elektrische Kontaktmaterialien von Bedeutung ist.

Nachfolgende wird die Leitfähigkeit für einige reine Elemente und Legierungen angegeben. Rhodiumbasislegierungen sind also eine hinsichtlich der Verbesserung der Leitfähigkeit interessant. Iridium erfüllt ebenfalls diese Anforderungen, dafür lässt sich das Material nicht so gut ätzen wie erfindungsgemäße Rhodiumbasislegierungen. Diese Eigenschaft ist wichtig für einen effizienten Herstellungsweg von Nadelspitzen. Die erfindungsgemäßen Rhodiumbasislegierungen lassen sich also Ätzen statt die Spitzen der Prüfnadeln aufwendig anschleifen zu müssen.

Kupfer hat eine Leitfähigkeit von 59 10⁶ A/(V m), Rhodium 23,3 10⁶ A/(V m), Platin 9,43 10⁶ A/(V m), Palladium 9,26 10⁶ A/(V m), PtNi20, eine Legierung, die vor allem im Asiatischen Raum als Standard verwendet wird, 3,77 10⁶ A/(V m)und Pd35Ag30Au10Pt10CuZn 5,8 10⁶ A/(V m), wobei letztere Legierung ein weit verbreitetes Prüfnadelmaterial ist.

Wie bereits zuvor begründet, ist die elektrische Leitfähigkeit von zentraler Bedeutung für die Funktion der Materialien in der elektrischen Kontakttechnik. Die erfindungsgemäßen Rhodiumbasislegierungen haben trotz einer Leitfähigkeitsverschlechterung von bis zu 20% durch das Zulegieren von Zirkonium (Zr), Cer (Ce), Yttrium (Y) eine sehr hohe Leitfähigkeit im Vergleich zu den bekannten Legierungen für Prüfnadeln. Diese ist deutlich höher als die am Markt befindlichen Materialien PtNi, PdAgCu mit einer elektrischen Leitfähigkeit von weniger als 7 10⁶ A/(V m).

Für Rhodiumbasislegierungen mit weniger als jeweils 100 ppm Zirkon sowie 100 ppm bis 1,1 Gew% Yttrium und Cer und dem Rest Rhodium und für Rhodiumbasislegierungen mit 1,1 Gew% Zirkon und dem Rest Rhodium konnten Drähte, hergestellt wie Beschrieben, nur mit häufigen Drahtabrissen von mindestens 17 Drahtabrissen pro 100 m Draht gezogen werden. Da ein Serienprozess wegen der häufigen Drahtabrisse für diese Legierungen nicht denkbar ist, wurde die maximale Ausbringung von Draht zu Draht nicht bestimmt.

Aufgrund von Überlegungen der Erfinder betreffend die Mischbarkeit und Legierbarkeit von Platin und Iridium zu Rhodium sowie den Materialeigenschaften solcher Mischungen und Legierungen wird gefolgert, dass ein Zulegieren von Platin und/oder Iridium zu erfindungsgemäßen Rhodiumbasislegierungen die Materialeigenschaften in Summe positiv beeinflussen. Daher sind Rhodiumbasislegierungen mit 0,01 Gew% bis 1 Gew% Zirkonium sowie 0,01 Gew% bis 30 Gew% Platin und/oder 0,01 Gew% bis 30 Gew% Iridium besonders bevorzugte erfindungsgemäße Rhodiumbasislegierungen.

Die vollständige Mischbarkeit der Elemente Rhodium und Platin ab 4 Gew% Platin sowie die vollständige Mischbarkeit der Elemente Rhodium und Iridium ab 5 Gew% Iridium kann aus den entsprechenden binären Phasendiagrammen abgelesen werden und wird somit auch für die erfindungsgemäßen Rhodiumbasislegierungen gefolgert.

Durch das Zulegieren von Platin wird wahrscheinlich das E-modul verringert und die Elastizität erfindungsgemäßer Rhodiumbasislegierungen erhöht. Dies ist eine vorteilhafte Eigenschaft für Kontaktteile, insbesondere Prüfnadeln, die einer häufigen Wechselbelastung ausgesetzt sind.

Die industrielle Anwendbarkeit erfindungsgemäßer Legierungen ist, wie zuvor beschrieben, dadurch gegeben, dass sich aus diesen Legierungen Drähte zur Herstellung von Prüfnadeln herstellen lassen, die eine hohe elektrische und thermische Leitfähigkeit besitzen und gleichzeitig eine hohe Härte, die zur Messung der Kontaktierung von integrierten Schaltungen (ICs) besser sind, als Prüfnadeln aus reinem Rhodium und anderen bekannten Legierungen, die zu diesem Zweck verwendet werden. Besonders vorteilhaft sind auch die bessere Verschleißbeständigkeit und die geringere Oxidation der Oberfläche der erfindungsgemäßen Legierungen bei erfindungsgemäßem Einsatz als Prüfnadel als reines Rhodium.

Die in der voranstehenden Beschreibung, sowie den Ansprüchen, Figuren und Ausführungsbeispielen offenbarten Merkmale der Erfindung können sowohl einzeln, als auch in jeder beliebigen Kombination für die Verwirklichung der Erfindung in ihren verschiedenen Ausführungsformen wesentlich sein.

### Bezugszeichenliste

- 1: Prüfnadel
- 2: Goldpad
- 4: Auflage / Wafer
- 6: Elektrische Leitung
- 8: Spannungsmessgerät
- 10: RhZr0,2-Rhodiumbasislegierung
- 11: RhZr0,5Y0,05Ce0,05-Rhodiumbasislegierung
- 12: RhZr0,2Y0,005Ce0,005-Rhodiumbasislegierung
- 13: RhZr0,5-Rhodiumbasislegierung

## Patentansprüche

1. Prüfnadel umfassend einen Draht aus einer Rhodiumbasislegierung, **dadurch gekennzeichnet, dass** die Rhodiumbasislegierung 0,01 Gew% bis 1 Gew% Zirkonium, optional 0,001 Gew% bis 1 Gew% Yttrium und/oder 0,001 Gew% bis 1 Gew% Cer und/oder 0,01 Gew% bis 30 Gew% Platin und/oder 0,01 Gew% bis 30 Gew% Iridium umfasst, vorzugsweise 0,01 Gew% bis 0,5 Gew% Yttrium und/oder 0,01 Gew% bis 0,5 Gew% Cer und/oder 5 Gew% bis 30 Gew% Platin und/oder 4 Gew% bis 30 Gew% Iridium, ganz besonders bevorzugt 5 Gew% bis 15 Gew% Platin und/oder 4 Gew% bis 15 Gew% Iridium, und der Rest der Rhodiumbasislegierung aus Rhodium besteht, wobei der Draht einen Durchmesser von 20 µm bis 200 µm aufweist.

2. Die Prüfnadel nach Anspruch 1, **dadurch gekennzeichnet, dass** der Draht einen Durchmesser von 50 µm bis 150 µm, vorzugsweise einen Durchmesser von 70 µm bis 90 µm aufweist.

3. Die Prüfnadel nach einem der vorangehenden Ansprüche, **dadurch gekennzeichnet, dass** die Rhodiumbasislegierung eine Kornfeinung aufweist, insbesondere ein gleichkörniges Feingefüge aufweist.

4. Die Prüfnadel nach Anspruch 3, **dadurch gekennzeichnet, dass** die mittlere Korngröße der Rhodiumbasislegierung zwischen 0,01 µm und 2 µm liegt, vorzugsweise zwischen 0,02 µm und 0,5 µm, besonders bevorzugt zwischen 0,05 µm und 0,1 µm.

5. Die Prüfnadel nach einem der vorangehenden Ansprüche, **dadurch gekennzeichnet, dass** die Rhodiumbasislegierung eine Härte von 350 HV bis 800 HV, vorzugsweise im zieharten Zustand einen Härte von 500 HV bis 750 HV und/oder in einem wärmebehandelten Zustand eine Härte von 400 HV bis 650 HV hat.

6. Die Prüfnadel nach einem der vorangehenden Ansprüche, **dadurch gekennzeichnet, dass** die Rhodiumbasislegierung einen spezifischen Widerstand zwischen 5 µΩ cm und 5,5 µΩ cm aufweist.

7. Die Prüfnadel nach einem der vorangehenden Ansprüche, **dadurch gekennzeichnet, dass** die Rhodiumbasislegierung eine kubisch flächenzentrierte Kristallstruktur aufweist.

8. Die Prüfnadel nach einem der vorangehenden Ansprüche, **dadurch gekennzeichnet, dass** die Rhodiumbasislegierung 0,05 Gew% bis 0,8 Gew% Zirkonium umfasst, bevorzugt 0,1 Gew% bis 0,6 Gew% Zirkonium, weiter bevorzugt 0,2 Gew% bis 0,5 Gew% Zirkonium.

9. Die Prüfnadel nach einem der vorhergehenden Ansprüche, **dadurch gekennzeichnet, dass** der Draht mit einem Spannungsprüfer elektrisch verbunden ist, wobei der Spannungsprüfer an ein zu prüfendes elektrisches Bauteil anschließbar oder angeschlossen ist.

10. Verfahren zur Herstellung einer Prüfnadel (1) nach einem der Ansprüche 1 bis 9, **dadurch gekennzeichnet, dass** der Draht aus der metallischen Legierung hergestellt, insbesondere gezogen oder gewalzt wird und das Material anschließend durch eine Temperaturbehandlung gehärtet wird, wobei die Härte durch die Temperaturbehandlung eingestellt wird, wobei die Prüfnadel (1) aus dem Draht geformt wird.

11. Verfahren nach Anspruch 10, **dadurch gekennzeichnet, dass** die Temperaturbehandlung bei einer Temperatur zwischen 150 °C und 600 °C erfolgt, bevorzugt bei einer Temperatur zwischen 200 °C und 400 °C, und die Temperaturbehandlung über einen Zeitraum von zumindest 10 Minuten erfolgt.

12. Verfahren nach Anspruch 10 oder 11, **dadurch gekennzeichnet, dass** die Spitze der Prüfnadel (1) durch Ätzen geformt wird.

## Claims

1. Test needle comprising a wire made of a rhodium-based alloy, **characterised in that** the rhodium-based alloy comprises 0.01% by weight to 1% by weight zirconium, optionally 0.001% by weight to 1% by weight yttrium and/or 0.001% by weight to 1% by weight cerium and/or 0.01% by weight to 30% by weight platinum and/or 0.01% by weight to 30% by weight iridium, preferably 0.01% by weight to 0.5% by weight yttrium and/or 0.01% by weight to 0.5% by weight cerium and/or 5% by weight to 30% by weight platinum and/or 4% by weight to 30% by weight iridium, most preferably 5% by weight to 15% by weight platinum and/or 4% by weight to 15% by weight iridium, and **in that** the remainder of the rhodium-based alloy consists of rhodium, whereby the wire has a diameter ranging from 20 µm to 200 µm.

2. The test needle according to claim 1, **characterised in that** the wire has a diameter ranging from 50 µm to 150 µm, preferably a diameter ranging from 70 µm to 90 µm.

3. The test needle according to any one of the preceding claims, **characterised in that** the rhodium-based alloy has grain refinement, in particular comprises an even-grained microstructure.

4. The test needle according to claim 3, **characterised in that** the average grain size of the rhodium-based alloy is between 0.01 µm and 2 µm, preferably between 0.02 µm and 0.5 µm, particularly preferably between 0.05 µm and 0.1 µm.

5. The test needle according to any one of the preceding claims, **characterised in that** the rhodium-based alloy has a hardness ranging from 350 HV to 800 HV, preferably in the as-drawn condition has a hardness ranging from 500 HV to 750 HV and/or in a heat-treated condition has a hardness ranging from 400 HV to 650 HV.

6. The test needle according to any one of the preceding claims, **characterised in that** the rhodium-based alloy has a resistivity ranging from 5 µΩ cm to 5.5 µΩ cm.

7. The test needle according to any one of the preceding claims, **characterised in that** the rhodium-based alloy comprises a face-centred cubic crystal structure.

8. The test needle according to any one of the preceding claims, **characterised in that** the rhodium-based alloy comprises 0.05% by weight to 0.8 percent by weight zirconium, preferably 0.1% by weight to 0.6% by weight zirconium, more preferably 0.2% by weight to 0.5% by weight zirconium.

9. The test needle according to any one of the preceding claims, **characterised in that** the wire is electrically connected to a voltage tester, whereby the voltage tester can be or is connected to an electrical component to be tested.

10. Method for the production of a test needle (1) according to any one of the claims 1 to 9, **characterised in that** the wire is produced, in particular is drawn or rolled, from the metallic alloy, and **in that** the material is subsequently hardened by a temperature treatment, whereby the hardness is being adjusted by the temperature treatment, whereby the test needle (1) is being formed from the wire.

11. Method according to claim 10, **characterised in that** the temperature treatment takes place at a temperature ranging from 150°C to 600°C, preferably at a temperature ranging from 200°C to 400°C, and **in that** the temperature treatment takes place over a period of time of at least 10 minutes.

12. Method according to claim 10 or 11, **characterised in that** the tip of the test needle (1) is formed by etching.

## Revendications

1. Aiguille d'essai comprenant un fil en un alliage à base de rhodium, **caractérisée en ce que** l'alliage à base de rhodium comprend 0,01 % en poids à 1 % en poids de zirconium, en option 0,001 % en poids à 1 % en poids d'yttrium et/ou 0,001 % en poids à 1 % en poids de cérium et/ou 0,01 % en poids à 30 % en poids de platine et/ou 0,01 % en poids à 30 % en poids d'iridium, de préférence 0,01 % en poids à 0,5 % en poids d'yttrium et/ou 0,01 % en poids à 0,5 % en poids de cérium et/ou 5 % en poids à 30 % en poids de platine et/ou 4 % en poids à 30 % en poids d'iridium, de manière tout particulièrement préférée 5 % en poids à 15 % en poids de platine et/ou 4 % en poids à 15 % en poids d'iridium, et le reste de l'alliage à base de rhodium se compose de rhodium, dans laquelle le fil présente un diamètre de 20 µm à 200 µm.

2. Aiguille d'essai selon la revendication 1, **caractérisée en ce que** le fil présente un diamètre de 50 µm à 150 µm, de préférence un diamètre de 70 µm à 90 µm.

3. Aiguille d'essai selon une des revendications précédentes, **caractérisée en ce que** l'alliage à base de rhodium présente un affinage du grain, présente notamment une structure à grains fins uniforme.

4. Aiguille d'essai selon la revendication 3, **caractérisée en ce que** la granulométrie moyenne de l'alliage à base de rhodium se situe entre 0,01 µm et 2 µm, de préférence entre 0,02 µm et 0,5 µm, de manière particulièrement préférée entre 0,05 µm et 0,1 µm.

5. Aiguille d'essai selon une des revendications précédentes, **caractérisée en ce que** l'alliage à base de rhodium a une dureté de 350 HV à 800 HV, de préférence dans l'état de type d'étirage une dureté de 500 HV à 750 HV et/ou dans un état de traitement thermique une dureté de 400 HV à 650 HV.

6. Aiguille d'essai selon une des revendications précédentes, **caractérisée en ce que** l'alliage à base de rhodium présente une résistivité comprise entre 5 µΩ cm et 5,5 µΩ cm.

7. Aiguille d'essai selon une des revendications précédentes, **caractérisée en ce que** l'alliage à base de rhodium présente une structure cristalline à centrage de face cubique.

8. Aiguille d'essai selon une des revendications précédentes, **caractérisée en ce que** l'alliage à base de rhodium comprend 0,05 % en poids à 0,8 % en poids de zirconium, de préférence 0,1 % en poids à 0,6 % en poids de zirconium, de manière davantage préférée 0,2 % en poids à 0,5 % en poids de zirconium.

9. Aiguille d'essai selon une des revendications précédentes, **caractérisée en ce que** le fil est connecté électriquement à un détecteur de tension, dans laquelle le détecteur de tension peut être raccordé ou est raccordé à un composant électrique à tester.

10. Procédé de fabrication d'une aiguille d'essai (1) selon une des revendications 1 à 9, **caractérisé en ce que** le fil est fabriqué à partir de l'alliage métallique, notamment étiré ou laminé, et le matériau est ensuite durci par un traitement de température, dans lequel la dureté est réglée par le traitement de température, dans lequel l'aiguille d'essai (1) est moulée à partir du fil.

11. Procédé selon la revendication 10, **caractérisé en ce que** le traitement de température s'effectue à une température comprise entre 150°C et 600°C, de préférence à une température comprise entre 200°C et 400°C et le traitement de température s'effectue sur une durée d'au moins 10 minutes.

12. Procédé selon la revendication 10 ou 11, **caractérisé en ce que** la pointe de l'aiguille d'essai (1) est moulée par gravure.
